# EUROPÄISCHE PATENTSCHRIFT

(11) **EP 3 169 827 B1**
(45) Veröffentlichungstag und Bekanntmachung des Hinweises auf die Patenterteilung: **23.02.2022**
(21) Anmeldenummer: 15744509.9
(22) Anmeldetag: 15.07.2015
(51) Int. Cl.: C23C 28/00, F16J 9/26

(54) **STAHLKOLBENRING, UND VERFAHRENZUR HERSTELLUNG DESSELBEN**
STEEL PISTON RING, AND METHODFOR PRODUCING THE SAME
SEGMENT DE PISTON EN ACIER ET SON PROCEDE DE FABRICATION

(30) Priorität: 16.07.2014 DE 102014213822
(43) Veröffentlichungstag der Anmeldung: 24.05.2017
(73) Patentinhaber: Federal-Mogul Burscheid GmbH, 51399 Burscheid (DE)
(72) Erfinder: BAUER, Christiane, 51399 Burscheid (DE)
(74) Vertreter: Hoffmann Eitle
(86) Internationale Anmeldenummer: PCT/EP2015/066152
(87) Internationale Veröffentlichungsnummer: WO 2016/008920

(56) Entgegenhaltungen:
- WO-A1-03/098079
- WO-A1-2014/068040
- DE-A1-102008 017 583
- DE-A1-102011 089 284
- DE-B3-102006 003 480
- DE-T5-112012 001 018
- JP-A- 2007 298 103
- Anonym: "GOETZE?-Kolbenring-Handbuch", , 1 August 2008 (2008-08-01), page 2, 44, 45, XP055282876, Burscheid [DE] Retrieved from the Internet: URL:http://korihandbook.federalmogul.com/d e/ [retrieved on 2016-06-22]

## Beschreibung

### Technisches Gebiet

Die Erfindung betrifft einen Stahlkolbenring.

### Stand der Technik

Bei der Reduzierung der Kohlendioxidemissionen von Verbrennungsmotoren spielt der Kraftstoffverbrauch eine maßgebliche Rolle. Dieser wird unter anderem auch von den Reibungsverlusten der Gleitelemente im Motor, insbesondere im Bereich der Kolben, beeinflusst. Die Gleitelemente, beispielsweise Kolbenringe, weisen dabei Laufflächen auf, an denen sie mit einem Reibpartner in gleitendem Kontakt sind. Dieses tribologische System ist komplex und wird maßgeblich durch die Materialpaarung der Reibpartner bestimmt.

Es besteht daher ein Bedarf nach Gleitelementen in Verbrennungsmotoren, die über die gesamte Lebensdauer ein möglichst günstiges Reibungsverhalten aufweisen. Allerdings treten insbesondere bei modernen Motoren hohe thermische und mechanische Belastungen an den Gleitelementen auf.

Die Gleitelemente, wie z.B. Kolbenringe, Kolben oder Zylinderlaufbuchsen in Verbrennungsmotoren sollen daher über eine lange Lebensdauer sowohl niedrige Reibungskoeffizienten als auch eine hohe Verschleißbeständigkeit besitzen.

Aus dem Stand der Technik sind Kolbenringe bekannt, deren Flanken teilweise oder ganz nitriert sind und deren Laufflächen zumindest partiell eine anderweitige Beschichtung aufweisen.

So offenbart die DE 102 21 800 A1 einen Stahlkolbenring mit einer Lauffläche, einer Innenfläche sowie dazwischen vorgesehenen oberen und unteren Flanken, wobei die Lauffläche zumindest partiell mit einer thermischen Spritzschicht als Laufflächenbeschichtung versehen ist und zumindest auf den Flanken eine durch Plasmanitrieren erzeugte Nitrierschicht vorgesehen ist.

Die US 6 508 473 B1 beschreibt einen Kolbenring mit einer Nitrierschicht auf den oberen und unteren Flanken oder auf den oberen und unteren Flanken und der inneren Umfangsfläche, sowie eine durch Ionenplattieren gebildete Hartschicht auf der äußeren Umfangsfläche.

Aus der DE 10 2005 023 627 A1 geht ein Stahlkolbenring mit einer einseitig gekammerten Lauffläche vor, wobei die Lauffläche mit einer Mikrorisse aufweisenden Verschleissschutzschicht auf Basis von Chromkeramik überzogen ist und zumindest die Flanken mit einer Verschleiß reduzierenden Nitrierschicht versehen sind.

Die DE 10 2005 011 438 B3 offenbart ein Verfahren zur Erzeugung von Verschleissschutzschichten an einem aus Stahl oder Gusseisen bestehenden Kolbenringgrundkörper, wobei zunächst der Laufflächenbereich zumindest partiell mit einer mindestens einlagigen thermischen Spritzschicht auf Basis stickstoffaffiner metallischer Elemente versehen wird und anschließend zumindest die Flanken und die Lauffläche samt darauf aufgebrachter Spritzschicht einem Nitrierprozess unterzogen werden.

Derartige Gleitelemente weisen zwar Schichten mit zufriedenstellender Verschleißbeständigkeit auf, zeigen jedoch entweder keine Laufflächen mit besonders niedrigen Reibkoeffizienten oder keine ausreichende Haftung zwischen Substrat und Verschleissschutzschicht.

Des Weiteren sind aus dem Stand der Technik DLC-Beschichtungen auf Kolbenringlaufflächen bekannt. Diamantähnliche Kohlenstoffschichten (DLC) stellen eine metastabile Form von amorphem Kohlenstoff mit einem signifikanten Anteil an sp³-hybridisiertem Kohlenstoff dar, die besonders günstige tribologische Eigenschaften zeigen. Eine Zusammenfassung der möglichen DLC Schichtsysteme findet sich in der VDI Richtlinie 2840 *Kohlenstoffschichten.*

DE 10 2011 003 254 A1 offenbart ein Gleitelement, wobei zumindest eine Lauffläche von innen nach außen eine Beschichtung mit einer metallhaltigen Haftschicht und einer DLC-Schicht des Typs ta-C mit einer Dicke von mindestens 10 µm aufweist. Das Grundmaterial des Gleitelementes kann hierbei nitriert oder nicht nitriert sein.

Derartige Gleitelemente weisen einen niedrigen Reibkoeffizienten auf der Lauffläche auf, sind jedoch nicht ausreichend verschleißbeständig.

Aus der DE 10 2011 014 483 B3 ist ein Verfahren zur Herstellung eines Stahlkolbenrings bekannt, bei dem ein laufflächenseitig mit einer Kammerung versehener Grundkörper erzeugt wird, die Lauffläche unmittelbar mit einer verschleißfesten Schicht versehen wird und die nicht mit der verschleißfesten Schicht versehenen Umfangs- und Flankenbereiche des Grundkörpers nitriert werden. Die verschleißfeste Schicht kann unter anderem aus einer DLC-Schicht oder einer Chromschicht bestehen, auf der DLC-Schicht kann auch eine Chromschicht aufgebracht werden.

Aufgrund der unmittelbaren Applikation der DLC-Schicht auf dem Substrat der Lauffläche wird jedoch die Verschleißbeständigkeit des Gleitelementes durch die ungenügende Haftung der DLC-Schicht auf der Lauffläche limitiert.

DE 102011089284 A1 offenbart einen Kolbenring für einen Verbrennungsmotor und ein Herstellungsverfahren dafür.

JP 2007298103 A offenbart einen Kolbenring für Verbrennungsmotoren.

### Darstellung der Erfindung

Der Erfindung liegt die Aufgabe zugrunde, einen Stahlkolbenring bereitzustellen, welcher sowohl eine insgesamt gute Verschleißbeständigkeit als auch günstige tribologische Eigenschaften im Bereich der Lauffläche aufweist.

Die Lösung dieser Aufgabe erfolgt durch den beanspruchten Stahlkolbenring.

Die Oberflächenhärtung der Flächen, die nicht die Lauffläche darstellen, gewährleistet dabei die Verschleißbeständigkeit derselben. Als äußerste Schicht der Lauffläche ist dagegen eine DLC-Schicht vorgesehen, die zu besonders vorteilhaften tribologischen Eigenschaften und Verschleißverhalten der Lauffläche beiträgt.

In diversen Versuchsreihen hat sich überraschenderweise gezeigt, dass mit einer DLC-Schicht versehene Substrate ohne Nitrierschicht eine deutlich höhere Beständigkeit gegenüber einer der klopfenden Verbrennung nachgestellten zyklischen Belastung aufweisen als Substrate, die unter der DLC-Schicht oder metallbasierten Nitridschicht eine Nitrierschicht aufweisen.

Aufgrund der Belastung erfolgt eine plastische Verformung des Substrats, die Sprödigkeit der Nitrierschicht führt dabei jedoch zur Rissinitiierung in dem nitrierten Bereich und der DLC-Schicht. Bei einem Substrat ohne Nitrierschicht können dagegen deutlich höhere Spannungen durch plastische Verformung abgebaut werden, bevor Rissbildung in dem Material initiiert wird. Die DLC-Schicht wird dabei aufgrund ihrer, im Vergleich zum Substrat, geringen Schichtdicke elastisch verformt.

Durch die Applikation einer metallhaltigen Zwischenschicht, konkret zweier Chromzwischenschichten, zwischen Substrat und DLC-Schicht kann die Haftung zwischen Substrat und DLC-Schicht darüber hinaus signifikant verbessert werden.

Der Aufbau der Beschichtung auf der Lauffläche gemäß Anspruch 1 gewährleistet dabei den Laufflächenverschleißschutz bei geringen Reibkoeffizienten, während die Verschleißbeständigkeit der Flächen, die nicht die Lauffläche darstellen, durch die Oberflächenhärtung sichergestellt wird.

Die Lauffläche entspricht der äußeren Umfangsfläche eines Rings mit polygonaler Querschnittsfläche, bevorzugt eines Hohlzylinders oder eines Hohlkegelstumpfs, ohne Kammerung. Das Auftragen der DLC-Schicht erfolgt zwangsläufig nach dem Auftragen der Zwischenschicht, die Oberflächenhärtung mindestens einer Fläche, die nicht die Lauffläche darstellt, kann dagegen vor dem Auftragen der Zwischenschicht, nach dem Auftragen der Zwischenschicht aber vor dem Auftragen der DLC-Schicht und/oder nach dem Auftragen der DLC-Schicht. Bevorzugte Weiterbildungen des erfindungsgemäßen Stahlkolbenrings sind in den Unteransprüchen 2 und 3 beschrieben.

Gemäß der Erfindung weist die die äussere Umfangsfläche, die die Lauffläche des Kolbenrings darstellt, keine Nitrierschicht auf. Der Verzicht auf eine Oberflächenhärtung unter der Beschichtung der Lauffläche erhöht maßgeblich die Verschleißbeständigkeit, da die Rissinitiierung analog zum Wirkmechanismus bei der nitrierten Lauffläche deutlich vermindert werden kann.

Vorliegend stellen die erfindungsgemäßen metallhaltigen Zwischenschichten Galvanik- und PVD-Zwischenschichten dar, da diese die Haftung positiv beeinflussen.

Gemäß der Erfindung grenzt eine metallhaltige Zwischenschicht, konkret eine Galvanik-Cr-Zwischenschicht, unmittelbar an die Substratoberfläche, so dass die Haftung weiter verbessert wird.

Mit Vorteil weist eine Galvanik-Cr-Zwischenschicht, eine Schichtdicke von 1 µm bis kleiner 5 µm auf, da diese die Lebensdauer der Beschichtung positiv beeinflusst.

Ein Verfahren zur Herstellung eines Gleitelementes sieht vor, dass eine metallhaltige Zwischenschicht über ein Galvanikverfahren aufgebracht wird. Hierdurch können mittels einfacher Verfahren kostengünstig metallhaltige Zwischenschichten abgeschieden werden.

Mit Vorteil wird zur Herstellung eine metallhaltige Cr-Zwischenschicht und eine DLC-Schicht über ein PVD-Verfahren aufgebracht. Dadurch können zuverlässig Schichten definierter Schichtdicke und chemischer Zusammensetzung abgeschieden werden.

Gemäß einer bevorzugten Ausführungsform weisen die oberflächengehärteten Oberflächen keine Beschichtung auf, wenngleich sie in besonderen Anwendungsfällen durchaus beschichtet sein können.

Als besonders vorteilhaft, aber nicht teil der vorliegenden Erfindung, haben sich metallbasierte Nitridschichten mit Nitriden der folgenden Elemente erwiesen:
Aluminium (Al), Titan (Ti), Zirkonium (Zr), Hafnium (Hf), Vanadium (V), Niob (Nb), Tantal (Ta), Chrom (Cr), Molybdän (Mo) und Wolfram (W). Besonders bevorzugt sind die Zusammensetzungen CrN, CrN(O), VN und AlN. Bevorzugt sind weiterhin Dreistoffsysteme A-B-N wobei A und B jeweils ein Element aus der Gruppe Ti, Zr, Hf, V, Nb, Ta, Cr, Mo, W, Al, Si und C ist und N Stickstoff entspricht. Besonders bevorzugt sind die Systeme Ti-Zr-N, Ti-Al-N, Cr-Si-N, Cr-Zr-N, Cr-Ti-N und Cr-V-N. Dabei kann es sich um stöchiometrische Phasen oder um nicht-stöchiometrische Phasen oder Mischungen daraus handeln. Die metallbasierten Nitridschichten können ferner beliebige Kombinationen der genannten Zusammensetzungen aufweisen, insbesondere können diese auch gradiert vorgesehen sein. Weiterhin können diese Droplets aufweisen und als Viellagenschichtsystem oder mit Übergitterstrukturen ausgebildet sein.

Darüber hinaus sind metallbasierte Nitridschichten in folgenden Dokumenten beschrieben:
DE102012200378 A1
DE102008017583 A1
DE102007027245 A1
DE102007035502 A1
DE102006046915 B3
DE102006046917 B3
DE102004032403 B3

Gemäß Anspruch 1 ist ein Stahlkolbenring mit einer oberen und unteren Flanke sowie einer inneren und äußeren Umfangsfläche vorgesehen. Die obere und untere Flanke sowie die innere Umfangsfläche weisen jeweils eine Nitrierschicht auf, die zum Beispiel durch Plasmanitrieren, Badnitrieren oder Gasnitrieren in den Kolbenring eingebracht wird. Auf der äußeren Umfangsfläche, die die Lauffläche des Kolbenrings darstellt und nicht nitriert ist, ist eine Beschichtung aufgebracht, bestehend aus einer ersten Chromzwischenschicht, bevorzugt mit einer Schichtdicke zwischen 1 µm und 5 µm, einer zweiten Chromzwischenschicht und einer DLC-Schicht des Typs ta-C. Die erste Chromzwischenschicht wird dabei durch galvanische Abscheidung auf der Lauffläche aufgebracht, die zweite Chromzwischenschicht und die DLC-Schicht werden mittels PVD-Verfahren abgeschieden.

## Patentansprüche

1. Stahlkolbenring mit einer oberen und unteren Flanke sowie einer inneren und äußeren Umfangsfläche, wobei
die obere und untere Flanke sowie die innere Umfangsfläche jeweils eine Nitrierschicht aufweisen,
auf der äußeren Umfangsfläche, die die Lauffläche des Kolbenrings darstellt und nicht nitriert ist, eine Beschichtung aufgebracht ist, die aus einer ersten Chromzwischenschicht, einer zweiten Chromzwischenschicht und einer DLC-Schicht des Typs ta-C besteht, und
die erste Chromzwischenschicht durch galvanische Abscheidung auf der Lauffläche aufgebracht wurde, und die zweite Chromzwischenschicht und die DLC-Schicht mittels PVD-Verfahren abgeschieden wurden.

2. Stahlkolbenring nach Anspruch 1, wobei
die Nitrierschicht durch Plasmanitrieren, Badnitrieren oder Gasnitrieren in den Kolbenring eingebracht wurde.

3. Stahlkolbenring nach Anspruch 1 oder 2, wobei die Schichtdicke der ersten Chromzwischenschicht zwischen 1 µm und 5 µm beträgt.

## Claims

1. Steel piston ring having an upper and lower flank and an inner and outer circumferential surface, wherein
the upper and lower flank and the inner circumferential surface each comprise a nitriding layer,
a coating consisting of a first chromium intermediate layer, a second chromium intermediate layer and a DLC layer of the ta-C type is applied to the outer circumferential surface, which constitutes the running surface of the piston ring and which is not nitrided, and
the first chromium intermediate layer was applied to the running surface by means of galvanic deposition, and the second chromium intermediate layer and the DLC layer were deposited by means of PVD processes.

2. Steel piston ring according to claim 1, wherein the nitriding layer was introduced into the piston ring by means of plasma nitriding, bath nitriding or gas nitriding.

3. Steel piston ring according to claim 1 or 2, wherein the layer thickness of the first chromium intermediate layer is between 1 µm and 5 µm.

## Revendications

1. Segment de piston en acier avec un flanc supérieur et inférieur ainsi qu'une surface périphérique intérieure et extérieure, dans lequel
les flancs supérieur et inférieur ainsi que la surface périphérique intérieure présentent respectivement une couche de nitruration,
sur la surface périphérique extérieure, qui représente la surface de roulement du segment de piston et qui n'est pas nitrurée, un revêtement est appliqué, qui est constitué d'une première couche intermédiaire de chrome, d'une seconde couche intermédiaire de chrome et d'une couche DLC de type ta-C, et
la première couche intermédiaire de chrome a été appliquée sur la surface de roulement par séparation galvanique, et la seconde couche intermédiaire de chrome et la couche DLC ont été séparées au moyen d'un procédé PVD.

2. Segment de piston en acier selon la revendication 1, dans lequel
la couche de nitruration a été appliquée dans le segment de piston par nitruration au plasma, nitruration en bain ou nitruration au gaz.

3. Segment de piston en acier selon la revendication 1 ou 2, dans lequel l'épaisseur de couche de la première couche intermédiaire de chrome est comprise entre 1 µm et 5 µm.
